# EUROPÄISCHE PATENTSCHRIFT

(11) **EP 2 599 120 B1**
(45) Veröffentlichungstag und Bekanntmachung des Hinweises auf die Patenterteilung: **08.11.2017**
(21) Anmeldenummer: 11741551.3
(22) Anmeldetag: 22.07.2011
(51) Int. Cl.: H01L 25/075, H01L 33/50, H01L 33/58, H01L 33/54, H01L 33/30, H01L 33/32, H01L 33/60, H01L 33/56

(54) **OPTOELEKTRONISCHES BAUELEMENT**
OPTOELECTRONIC COMPONENT
COMPOSANT OPTOÉLECTRONIQUE

(30) Priorität: 26.07.2010 DE 102010038396
(43) Veröffentlichungstag der Anmeldung: 05.06.2013
(73) Patentinhaber: OSRAM Opto Semiconductors GmbH, 93055 Regensburg (DE)
(72) Erfinder: LINKOV, Alexander, 93059 Regensburg (DE); WIRTH, Ralph, 93138 Lappersdorf (DE)
(74) Vertreter: Epping - Hermann - Fischer
(86) Internationale Anmeldenummer: PCT/EP2011/062598
(87) Internationale Veröffentlichungsnummer: WO 2012/016850

(56) Entgegenhaltungen:
- WO-A1-2004/031844
- WO-A1-2009/069671
- WO-A2-2010/054622
- DE-A1-102009 018 088
- US-A1- 2004 217 364
- US-A1- 2005 045 897
- US-A1- 2007 228 392
- US-A1- 2008 079 014
- US-A1- 2010 140 648

## Beschreibung

Die vorliegende Erfindung betrifft ein optoelektronisches Bauelement zur Mischung von elektromagnetischer Strahlung verschiedener Wellenlängen und eine Leuchtvorrichtung mit einem solchen Bauelement.

Zur Erzeugung von Mischlicht aus elektromagnetischer Strahlung verschiedener Halbleiterchips wurden bislang Lichtboxen verwendet. Mit Hilfe der Lichtboxen können nur Fernfelder mit einer relativ engen Winkelverteilung der Intensität erzeugt werden. Insbesondere sind keine optoelektronischen Bauelemente bekannt, die schon an ihren Ausgangsfacetten weitestgehend gemischtes Licht zur Verfügung stellen.

Die Druckschrift US 2004/0217364 A1 ist auf LED-Leuchten mit mehreren LED-Chips zur Emission von weißem Licht gerichtet.

In der Druckschrift US 2008/0079014 A1 findet sich eine Beleuchtungseinrichtung mit mehreren LEDs und mit einer lichtstreuenden Schicht.

Aus der Druckschrift WO 2010/054622 A2 ist eine LED-Leuchte mit mehreren LEDs in einem konischen Reflektor bekannt.

Eine LED-Lichtquelle mit einem reflektierenden Verguss und mit einem Leuchtstoff ist der Druckschrift US 2010/0140648 A1 zu entnehmen.

Für eine LED-Leuchte mit einem LED-Chip in einem Reflektor, gefolgt von einer Streuschicht, findet sich eine Offenbarung in der Druckschrift DE 10 2009 018 088 A1.

In der Druckschrift US 2007/0228392 A1 ist eine LED-Leuchte mit einem Reflektor und einer Linse zur Lichtstromkonzentrierung beschrieben.

Ein Display mit Bildpunkten, die je aus mehreren LEDs gebildet sind, ist aus der Druckschrift WO 2004/031844 A1 bekannt.

LEDs in einem Vergusskörper, die von Konversionselementen abgedeckt sind, sind in der Druckschrift EP 2 216 834 A1 offenbart, korrespondierend zur Druckschrift WO 2009/0069671 A1.

Aus der Druckschrift US 2005/0045897 A1 sind LED-Chips auf einem reflektierenden Substrat bekannt, denen eine lichtstreuende Schicht nachgeordnet ist.

Eine Aufgabe der Erfindung ist es, ein optoelektronisches Bauelement mit Halbleiterchips, die elektromagnetische Strahlung in verschiedenen Spektralbereichen emittieren, vorzusehen, das schon an seiner Ausgangsfacette weitestgehend gemischtes Licht zur Verfügung stellt.

Diese Aufgabe wird durch ein optoelektronisches Bauelement und durch eine Leuchtvorrichtung gemäß der unabhängigen Ansprüche gelöst.

Weiterbildungen und vorteilhafte Ausgestaltungen des optoelektronischen Bauelements sind in den abhängigen Ansprüchen angegeben.

Das optoelektronische Bauelement dient zur Mischung von elektromagnetischer Strahlung mit verschiedenen Wellenlängen, insbesondere im Fernfeld.

Auf einem Träger ist ein erster Halbleiterchip mit einer ersten Strahlungsaustrittsfläche vorgesehen. Der erste Halbleiterchip emittiert elektromagnetische Strahlung in einem ersten Spektralbereich. Auf dem Träger ist ein zweiter Halbleiterchip mit einer zweiten Strahlungsaustrittsfläche vorgesehen. Der zweite Halbleiterchip emittiert elektromagnetische Strahlung in einem zweiten Spektralbereich. Auf den vom Träger abgewandten Strahlungsaustrittsflächen der Halbleiterchips ist eine Streuschicht vorgesehen. Dies ist vorteilhaft, da durch die Streuschicht eine Mischung der von den verschiedenen Halbleiterchips emittierten elektromagnetischen Strahlung schon auf Ebene des optoelektronischen Bauelements erfolgt.

Mit anderen Worten ist ein Kerngedanke der Erfindung, dass sich über der Halbleiterchipebene eine Streuschicht befindet, die Licht, das bereits auf direktem Weg ausgekoppelt werden könnte, streut und teilweise zurückwirft. Dies widerspricht scheinbar dem eigentlichen Bestreben des Fachmanns, eine möglichst hohe Transparenz auf der Strahlungsaustrittsfläche bereitzustellen. In der hier dargestellten Lösung wird eine möglichst wenig absorbierende Ausformung des Trägers, auf dem die Halbleiterchips montiert sind, vorgeschlagen, um eine Lichtabsorption durch die Halbleiterchips und/oder den Träger zu reduzieren. So trägt die Streuschicht wesentlich zu einer Durchmischung der von den Halbleiterchips emittierten Strahlung bei. Die Strahlung wird trotz der Streuung nur unwesentlich absorbiert und es wird ein erheblicher Teil der (durchmischten) Strahlung aus dem optoelektronischen Bauelement ausgekoppelt. Die Streupartikel wirken als optisches Mischelement.

Es basieren die Halbleitchips auf III-V-Verbindungshalbleitermaterialien. Die Halbleiterchips weisen mindestens eine aktive Zone auf, die elektromagnetische Strahlung emittiert. Die aktiven Zonen können pn-Übergänge, Doppelheterostruktur, Mehrfach-Quantentopfstruktur (MQW), Einfach-Quantentopfstruktur (SQW) sein. Quantentopfstruktur bedeutet: Quantentöpfe (3-dim), Quantendrähte (2-dim) und Quantenpunkte (1-dim).

Zwischen den vom Träger abgewandten Strahlungsaustrittsflächen der Halbleiterchips und der Streuschicht ist eine Konversionsschicht vorgesehen. Diese Konversionsschicht wandelt vorzugsweise kurzwellige elektromagnetische Strahlung in längerwellige elektromagnetische Strahlung. Weil die Konversionsschicht zwischen den Halbleiterchips und der Streuschicht angeordnet ist, wird ein weiterer Strahlungsanteil erzeugt, der in der Streuschicht mit den anderen Strahlungsanteilen durchmischt wird. Damit wird eine spektrale Aufweitung der emittierten Strahlung erzielt.

Der erste Halbleiterchip ist als AlGaInP-Halbleiterchip ausgebildet. Der AlGaInP-Halbleiterchip emittiert elektromagnetische Strahlung im roten und/oder gelben Spektralbereich. Der Einsatz eines AlGaInP-Halbleiterchip ist besonders vorteilhaft in Kombination mit einem blau emittierenden Halbleiterchip, dessen Spektrum durch ein Konversionsmittel teilweise in den gelben Spektralbereich konvertiert wird. Bei dieser Kombination kann durch den AlGaInP-Halbleiterchip ein warm-weißer Farbeindruck erzeugt werden.

Der zweite Halbleiterchip ist als InGaN-Halbleiterchip ausgebildet. Der InGaN-Halbleiterchip emittiert elektromagnetische Strahlung im blauen Spektralbereich. Der Einsatz eines InGaN-Halbleiterchip zur Emission von Strahlung im blauen Spektralbereich ist besonders vorteilhaft, um mit Hilfe eines Konversionsmittels weißes Licht zu erzeugen.

Vorzugsweise können mehrere AlGaInP-Halbleiterchips und/oder mehrere InGaN-Halbleiterchips vorgesehen sein. Dies ist besonders vorteilhaft, da dadurch eine hohe optische Ausgangsleistung erreicht werden kann.

In einer bevorzugten Ausführungsform sind im Zentrum des optoelektronischen Bauelements die AlGaInP-Halbleiterchips angeordnet. Die InGaN-Halbleiterchips können ringförmig und/oder mit einer gleichmäßigen Chipdichte um die AlGaInP-Halbleiterchips angeordnet werden. Dies ist vorteilhaft, da dadurch eine gleichmäßige Leuchtdichte erreicht werden kann.

In einer bevorzugten Ausführungsform sind der erste und der zweite Halbleiterchip in einem einzigen Verguss, insbesondere in Form eines planaren Volumenvergusses, vergossen. Die Halbleiterchips sind in einer Ebene angeordnet. Dies ist vorteilhaft, da dadurch eine hohe Packungsdichte der Halbleiterchips auf dem Träger erreicht werden kann. Als Vergussmaterial kann insbesondere Silikon, Epoxidharz oder ein Hybridmaterial verwendet werden.

In einer bevorzugten Ausführungsform ist in der Konversionsschicht als Konversionsmittel ein phosphoreszentes Material vorgesehen. Vorzugsweise handelt es sich um Leuchtstoffpartikel aus Yttrium-Gallium-Aluminium-Granat und/oder Lutetium Aluminium Granat. Das phosphoreszente Material liegt bei homogener Verteilung in der Konversionsschicht in einer Konzentration von 5 bis 25 Gewichtsprozent vor. Der Einsatz obiger Phosphore ist besonders vorteilhaft, da diese eine effiziente Konversion von Licht aus dem blauen Spektralbereich in Licht aus dem grünen bis gelben Spektralbereich ermöglichen.

In einer bevorzugten Ausführungsform sind in der Streuschicht als Streumittel Streupartikel vorgesehen. Vorzugsweise kommt Aluminiumdioxid, Siliziumdioxid oder Titandioxid, in einer Konzentration von 0,05 bis 50 Gewichtsprozent, zum Einsatz. Diese Partikel reflektieren Strahlung im sichtbaren Bereich gleichermaßen. Dies ist besonders vorteilhaft, da die Streupartikel das auftreffende Licht elastisch streuen und zu einer Durchmischung von Licht mit verschiedenen Wellenlängen beitragen. Insbesondere verfälschen sie nicht den Farbeindruck durch Absorption einiger Wellenlängen.

Die Konversionsschicht weist über dem ersten Halbleiterchip ein klares Vergussmaterial auf. Das klare Vergussmaterial ist in Form einer sogenannten "Lense on chip" auf den ersten Halbleiterchip aufgebracht. Die "Lense on chip" ist ein Tropfen klaren Vergussmaterials, der nach dem Aufbringen auf den ersten Halbleiterchip ausgehärtet wurde. Das klare Vergussmaterial über dem ersten Halbleiterchip ist besonders vorteilhaft, da dadurch die ungewollte Absorption von Licht durch phosphoreszentes Material in der Konversionsschicht über dem ersten Halbleiterchip verhindert wird. Falls der erste Halbleiterchip ein AlGaInP-Halbleiterchip ist, kann das rote Licht die Konversionsschicht ohne Absorptionsverluste durchdringen.

In einer bevorzugten Ausführungsform weist die Konversionsschicht über dem ersten Halbleiterchip, insbesondere über dem AlGaInP-Halbleiterchip, gemoldetes Glas oder ein Silikonplättchen auf. Dies ist besonders vorteilhaft, da dadurch die ungewollte Absorption von rotem Licht durch phosphoreszentes Material in der Konversionsschicht über dem AlGaInP-Halbleiterchip verhindert wird.

In einer bevorzugten Ausführungsform ist auf der dem Träger zugewandten Seite der Streuschicht eine freie Lichtmischschicht vorgesehen, die von Streumittel und Konversionsmittel befreit ist. Dies ist besonders vorteilhaft, da sich das Licht schon vor dem Auftreffen auf die Streuschicht zumindest teilweise durchmischen kann. Die freie Lichtmischschicht weist Silikon, Epoxid oder ein Hybridmaterial auf.

In einer bevorzugten Ausführungsform sind die Halbleiterchips als Oberflächenemitter, insbesondere als Dünnfilmchips ausgebildet. Diese Halbleiterchips sind bis zur Höhe ihrer aktiven Schichten in mit Titandioxid, TiO₂, gefülltem Silikon mit einer Reflektivität von größer 95% eingegossen. Alternativ kann das Silikon auch mit ZrO₂, Al₂O₃ oder ZnO gefüllt sein. Der Einsatz von hochreflektierendem gefüllten Silikon ist besonders vorteilhaft, da dadurch Absorptionsverluste durch freiliegende Bereiche des Trägers verhindert werden. Alternativ kann die den Halbleiterchips zugewandte Trägerfläche mit einer Reflexionsschicht, insbesondere aus Silber, beschichtet sein, was ebenfalls die Absorptionsverluste verringert.

In einer bevorzugten Ausführungsform weist die Streuschicht die Form einer Linse auf. Dies ist besonders vorteilhaft, da sich im Vergleich zur Streuschicht mit homogener Dicke, also ohne Linsenform, eine breitere Abstrahlcharakteristik ergibt. Mit anderen Worten verlässt mehr Licht das optoelektronische Bauelement unter größeren Winkeln, vorzugsweise bei Winkeln größer 60 Grad, besonders bevorzugt in Winkel größer 90 Grad. In je größere Winkel das Licht von dem optoelektronischen Bauelement abgestrahlt wird, desto effizienter kann das gemischte Licht von nachgeordneten Reflektoren in Vorwärtsrichtung abgestrahlt werden.

In einer bevorzugten Ausführungsform sind seitliche, reflektierende Wände vorgesehen, die auf dem Träger aufsetzen. Die Wände sind zum einen vorteilhaft, da sie beim Vergießen der Halbleiterchips als seitliche Begrenzung dienen. Zum anderen können die Wände hochreflektierend ausgelegt sein und dadurch mehr von der von den Halbleiterchips emittierten elektromagnetischen Strahlung in Richtung der Lichtausgangsfacette des optoelektronischen Bauelements reflektieren. Die seitlichen Wände können senkrecht auf dem Träger stehen. Alternativ können die seitlichen Wände schräg zum Träger stehen. Dies kann vorteilhaft sein, da dadurch mehr Licht in Richtung der Lichtaustrittsfläche des optoelektronischen Bauelements reflektiert werden kann. Durch schräge Wände kann ein größerer Lichtdurchmesser oder mit anderen Worten eine größere Lichtausgangsfacette erreicht werden.

Verschiedene Ausführungsformen weisen eine Leuchtvorrichtung mit einem solchen optoelektronischen Bauelement und einer Sekundäroptik auf. Vorzugsweise ist die Sekundäroptik ein Reflektor. Dies ist besonders vorteilhaft, da durch den nachgeschalteten Reflektor besonders einfach und effizient das im optoelektronischen Bauelement gemischte Licht in Vorwärtsrichtung abgestrahlt werden kann.

In einer bevorzugten Ausführungsform weist der Reflektor zumindest Bereichsweise die Form einer Parabel auf. Diese Reflektorform ist besonders vorteilhaft, da dadurch ein Großteil des vom optoelektronischen Bauelement abgestrahlten, gemischten Lichts in Vorwärtsrichtung abgestrahlt werden kann.

Verschiedene Abwandlungen und ein Ausführungsbeispiel der erfindungsgemäßen Lösung werden im Folgenden anhand der Zeichnungen näher erläutert.
- Figur 1: zeigt einen Schnitt durch eine nicht erfindungsgemäße Abwandlung eines optoelektronischen Bauelements;
- Figur 1a: zeigt das Abstrahlprofil des optoelektronischen Bauelements aus Figur 1;
- Figur 2: zeigt einen Schnitt durch eine nicht erfindungsgemäße Abwandlung eines optoelektronischen Bauelements;
- Figur 3: zeigt einen Schnitt durch ein erfindungsgemäßes Ausführungsbeispiel eines optoelektronischen Bauelements;
- Figur 4: zeigt einen Schnitt durch eine nicht erfindungsgemäße Abwandlung eines optoelektronischen Bauelements;
- Figur 5: zeigt einen Schnitt durch eine nicht erfindungsgemäße Abwandlung eines optoelektronischen Bauelements;
- Figur 6: zeigt einen Schnitt durch eine nicht erfindungsgemäße Abwandlung eines optoelektronischen Bauelements;
- Figur 6a: zeigt das Abstrahlprofil des optoelektronischen Bauelements aus Figur 6;
- Figur 7: zeigt einen Schnitt durch eine nicht erfindungsgemäße Abwandlung eines optoelektronischen Bauelements;
- Figur 8: zeigt einen Schnitt durch eine nicht erfindungsgemäße Abwandlung eines optoelektronischen Bauelements;
- Figur 9: zeigt die winkelabhängige Intensitätsverteilung der in den Figuren 1 bis 8 gezeigten optoelektronischen Bauelemente;
- Figur 10: zeigt einen Schnitt durch eine Leuchtvorrichtung.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und zum besseren Verständnis übertrieben groß dargestellt sein.

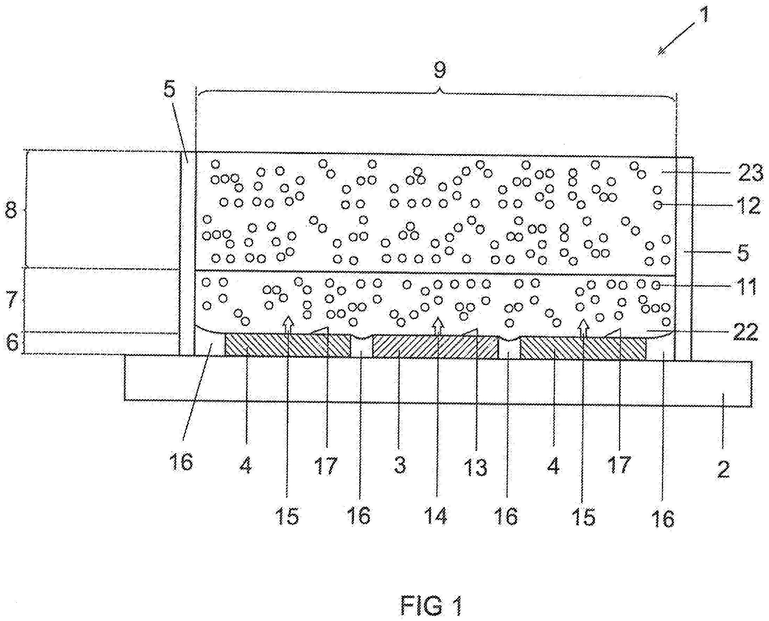

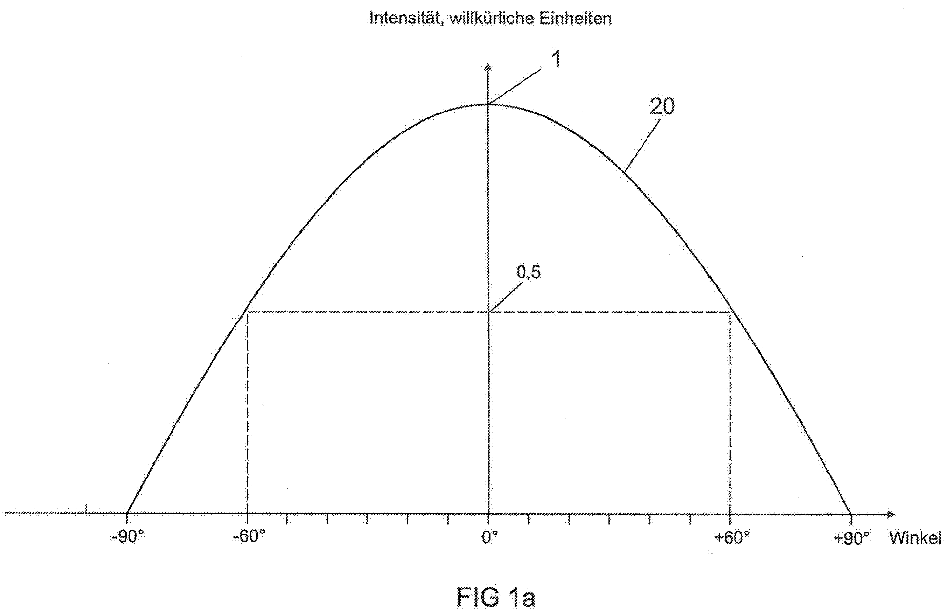

Figur 1 zeigt eine Schnittansicht durch eine Abwandlung eines optoelektronischen Bauelements 1. Das optoelektronische Bauelement 1 dient zur Mischung von elektromagnetischer Strahlung mit verschiedenen Wellenlängen, insbesondere im Fernfeld. Auf einem Träger 2 ist ein erster Halbleiterchip 3 mit einer ersten Strahlungsaustrittsfläche 13 zur Emission von elektromagnetischer Strahlung in einem ersten Spektralbereich 14 vorgesehen. Auf dem Träger 2 sind zwei weitere Halbleiterchips 4 mit einer zweiten Strahlungsaustrittsfläche 17 zur Emission von elektromagnetischer Strahlung in einem zweiten Spektralbereich 15 vorgesehen. Die Halbleiterchips 3,4 liegen in einer Ebene, der Halbleiterchipebene 6. Die Höhe dieser Halbleiterchipebene 6 liegt zwischen 0,05 mm und 0,3 mm, vorzugsweise bei etwa 0,2 mm. Auf den vom Träger 2 abgewandten ersten und zweiten Strahlungsaustrittsflächen 13, 17 der Halbleiterchips 3,4 ist eine Streuschicht 8 vorgesehen. In der Streuschicht 8 sind als Streumittel Streupartikel 12, insbesondere Aluminiumdioxid, Siliziumdioxid oder Titandioxid, in einer Konzentration von 0,05 bis 50 Gewichtsprozent, in einem Vergussmaterial 23 vorgesehen. Die Höhe der Streuschicht 8 entspricht dem mittleren lateralen Abstand zwischen dem ersten Halbleiterchip 3 und dem zweiten Halbleiterchip 4. Bei Halbleiterchips mit einer Fläche von 1mm² beträgt die Höhe der Streuschicht 8 vorzugsweise zwischen 1mm und 8mm, besonders bevorzugt 2mm. Die Halbleiterchips sind als Oberflächenemitter, insbesondere als Dünnfilmchips, ausgelegt. Der erste Halbleiterchip 3 ist als AlGaInP-Halbleiterchip ausgebildet, der elektromagnetische Strahlung im roten und/oder gelben Spektralbereich emittiert. Der zweite Halbleiterchip 4 ist als InGaN-Halbleiterchip ausgebildet, der elektromagnetische Strahlung im blauen und/oder grünen Spektralbereich emittiert. Zwischen den vom Träger 2 abgewandten Strahlungsaustrittsflächen 13, 17 der Halbleiterchips 3, 4 und der Streuschicht 8 ist eine Konversionsschicht 7 angeordnet. Die Konversionsschicht 7 wandelt elektromagnetische Strahlung aus dem blauen Spektralbereich 15 in den grünen bis gelben Spektralbereich. Die Konversionsschicht 7 weist vorzugsweise eine Höhe zwischen 0,1 mm und 0,8 mm, besonders bevorzugt 0,3 mm auf. Als Konversionsmittel ist ein phosphoreszentes Material 11, insbesondere Leuchtstoffpartikel aus Yttrium-Gallium-Aluminium-Granat und/oder Lutetium Aluminium Granat, vorgesehen. Das Konversionsmittel 11 liegt bei homogener Verteilung in einer Konzentration von 5 bis 25 Gewichtsprozent in einem Vergussmaterial 22 vor. Die InGaAlP- und InGaN-Halbleiterchips 3, 4 sind in einem einzigen Verguss, insbesondere in Form eines planaren Volumenvergusses, vergossen. Die Halbleiterchips 3, 4 sind bis zur Höhe ihrer aktiven Schichten in mit Titandioxid gefülltem Silikon 16 seitlich eingegossen. Die Reflektivität des mit Titandioxid gefüllten Silikon kann größer 95% sein. Es sind seitliche, reflektierende Wände 5 vorgesehen, die senkrecht auf dem Träger 2 aufsetzen. In einer nicht gezeigten Alternative stehen die seitlichen Wände 5 schräg auf dem Träger 2 und schließen mit dem Träger 2 einen Winkel ≠ 90 Grad ein. Der Lichtdurchmesser 9, also die laterale Ausdehnung der Lichtaustrittsfacette, kann zwischen 3mm und 50mm liegen. Typischerweise liegt der Lichtdurchmesser 9, zwischen 10mm und 20mm. Der Lichtstrom variiert bei den vorliegend beanspruchten Ausführungsbeispielen zwischen 1000 und 4000 Lumen.

Figur 1a zeigt schematisch das zum optoelektronischen Bauelement aus Figur 1 gehörige Abstrahlprofil. Das optoelektronische Bauelement weist ein Lambertsches Abstrahlprofil 20 auf. Die Strahlungsintensität in verschiedene Raumrichtungen ist proportional zum cosinus des Abstrahlwinkels. Dies bedeutet, dass bei 60 Grad Auslenkung von der Normalen (0 Grad) die Lichtintensität auf 50 % des Maximalwerts und bei 90 Grad auf 0% abgefallen ist. Die "full width at half maximum" beträgt 120 Grad, nämlich von -60 Grad bis +60 Grad.

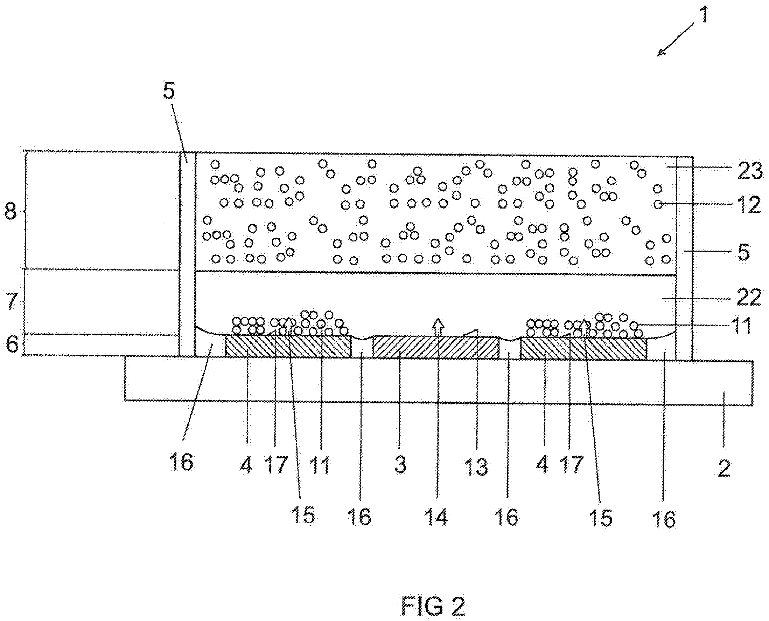

Figur 2 zeigt im Gegensatz zu Figur 1 eine Abwandlung, bei der das phosphoreszente Material 11 inhomogen in der Konversionsschicht 7 verteilt ist. Das phosphoreszente Material 11 liegt in Form von Plättchen vor, die auf der Strahlungsaustrittsfläche 17 der InGaN-Halbleiterchips 4 angeordnet sind. Die Plättchen sind zumindest bereichsweise in Vergussmaterial 22 eingebettet. Auf der Strahlungsaustrittsfläche 13 des InGaAlP-Halbleiterchips 3 ist kein phosphoreszentes Material 11 vorgesehen. Deshalb wird das von dem AlGaInP-Halbleiterchip 3 emittierte rote Licht nicht in der Konversionsschicht 7 absorbiert. Darüber hinaus gilt die Beschreibung von Figur 1 auch für Figur 2.

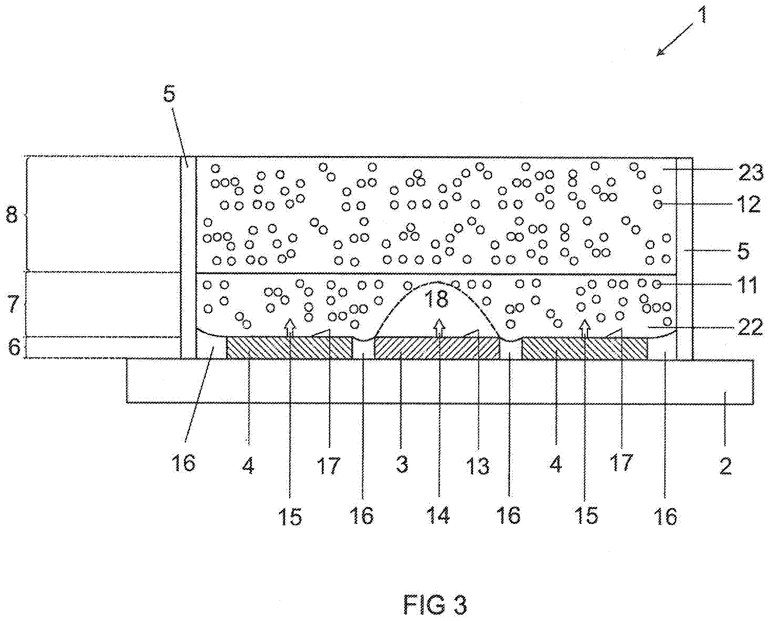

Figur 3 zeigt im Gegensatz zu Figur 1 ein Ausführungsbeispiel, bei dem das phosphoreszente Material 11 inhomogen verteilt ist. Bei der in Figur 1 gezeigten Abwandlung gehen durch die Leuchtstoffpartikel 11 über dem AlGaInP-Halbleiterchip 3 durch Streuung und/oder Absorption einige Prozent der Lichtintensität des roten Lichts verloren. Um diesen Effekt zu verringern, wird im in Figur 3 gezeigten Ausführungsbeispiel ein Tropfen klaren Vergussmaterials 18 auf die Strahlungsaustrittsfläche 13 des InGaAlP-Halbleiterchip 3 aufgebracht. Dies wird auch Lense on chip (LOC) genannt. Darüber hinaus gilt die Beschreibung von Figur 1 auch für Figur 3.

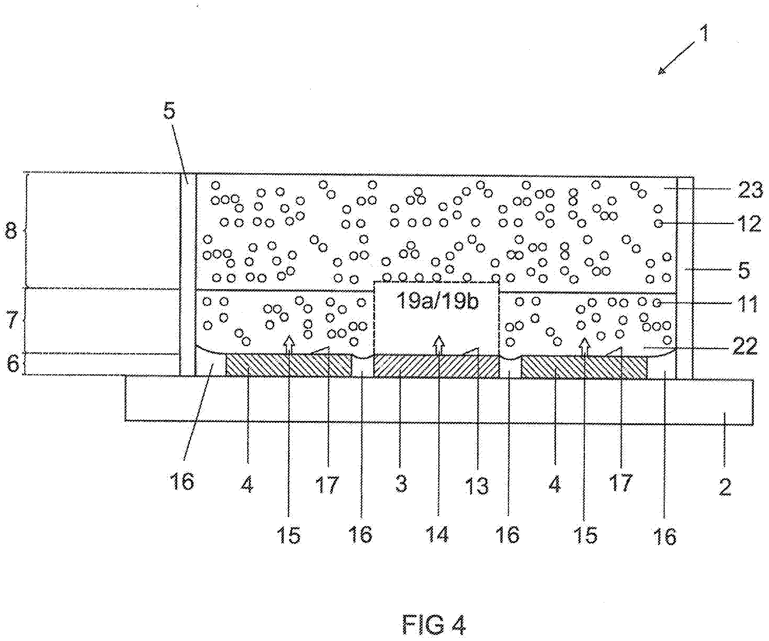

Figur 4 zeigt im Gegensatz zu Figur 1 eine Abwandlung, bei der das phosphoreszente Material 11 inhomogen verteilt ist. Um Streuung und/oder Absorption zu reduzieren wird auf die Strahlungsaustrittsfläche 13 des InGaAlP-Halbleiterchip 3 gemoldetes Glas 19a oder ein Silikonplättchen 19b aufgebracht. Das gemoldete Glas 19a und das Silikonplättchen 19b können in die Streuschicht hineinragen. Dadurch wird erreicht, dass keinerlei Leuchtstoffpartikel 11 über dem InGaAlP-Halbleiterchip 3 vorhanden sind. Darüber hinaus gilt die Beschreibung von Figur 1 auch für Figur 4.

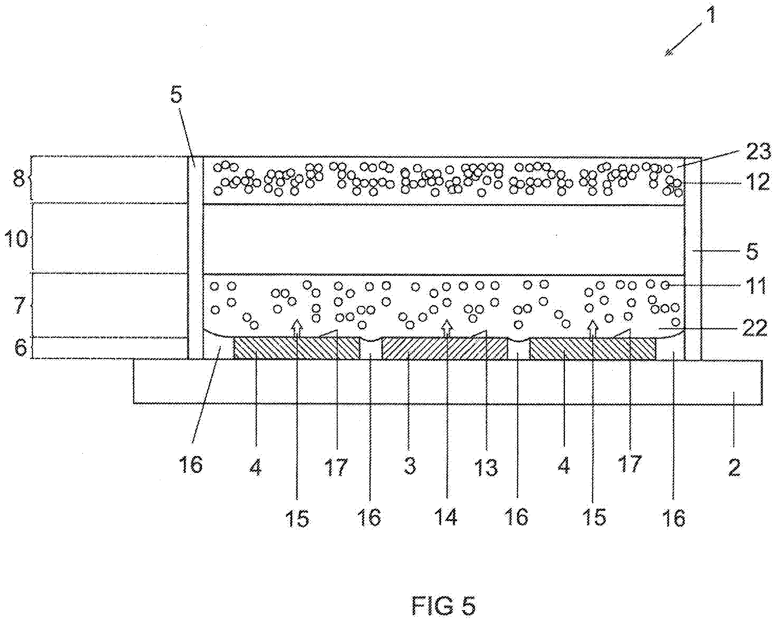

Figur 5 zeigt eine Abwandlung, bei der auf der dem Träger 2 zugewandten Seite der Streuschicht 8 eine freie Lichtmischschicht 10 vorgesehen ist. Die freie Lichtmischschicht 10 ist von Streupartikel 12 und phosphoreszentem Material 11 befreit. Die Dicke der freien Lichtmischschicht 10 beträgt zwischen 20 % und 98 %, vorzugsweise 50 %, der Gesamtdicke von Streuschicht 8 und freien Lichtmischschicht 10. Die Streuschicht 8 betrifft also nicht das gesamte Volumen oberhalb der Konversionsschicht 7, sondern befindet sich im oberen Lichtmischbereich. Durch die freie Propagation der elektromagnetischen Strahlung in der freien Lichtmischschicht 10 mischt sich das von den Halbleiterchips emittierte Licht teilweise bereits vor dem Auftreffen auf die Streuschicht 8. Darüber hinaus gilt die Beschreibung von Figur 1 auch für Figur 5.

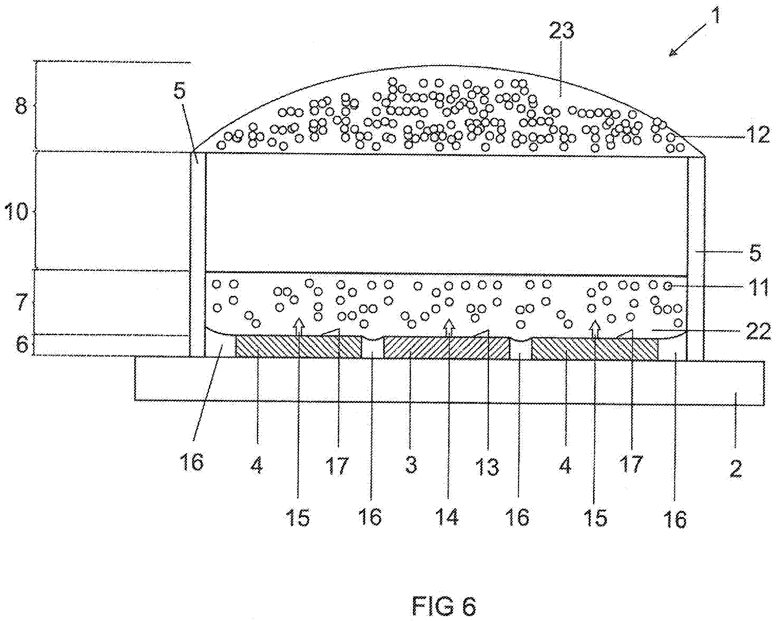

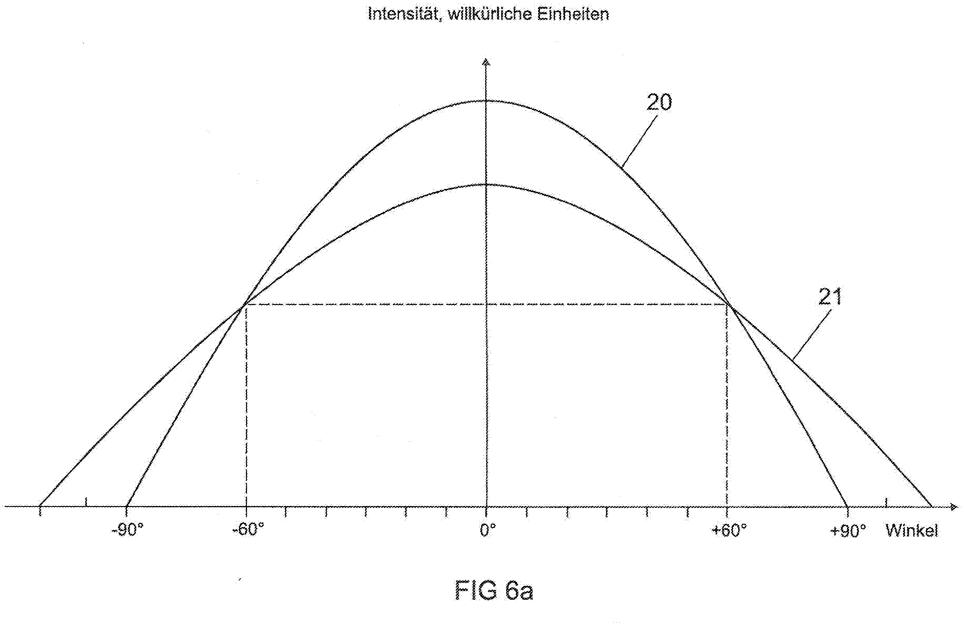

Figur 6 zeigt im Gegensatz zu Figur 5 eine Abwandlung, bei der die Streuschicht 8 die Form einer Linse aufweist. Die Streuschicht schließt bündig mit den seitlichen Wänden 5 ab. In der Mitte zwischen den seitlichen Wänden, weist die Streuschicht ihre maximale Dicke auf. Mit anderen Worten ist mittig die maximale Anzahl an Streupartikel 12 vorgesehen. Nach der freien Propagation in der freien Lichtmischschicht 10 trifft das von den Halbleiterchips 3, 4 emittierte Licht auf die Streupartikel 12. Dies führt zu einer Strahlungsverteilung, die bezüglich ihrer Winkelverteilung breiter ist als die Lambertsche Verteilung. Darüber hinaus gilt die Beschreibung von Figur 5 auch für Figur 6.

Figur 6a zeigt schematisch das zum optoelektronischen Bauelement aus Figur 6 gehörige Abstrahlprofil 21. Die Linsenform der Konversionsschicht 7 bedingt ein Abstrahlprofil 21 das bezüglich der Winkelverteilung breiter ist als ein lambertsches Abstrahlprofil 20. Das nicht-lambertsche Abstrahlprofil 21 zeigt für Winkel größer als etwa 60 Grad eine höhere Intensität als das lambertsche Abstrahlprofil. Zudem weist das nicht-lambertsche Abstrahlprofil 21 im Gegensatz zum lambertschen Abstrahlprofil 20 nicht verschwindende Intensitäten für Abstrahlwinkel größer als 90 Grad auf.

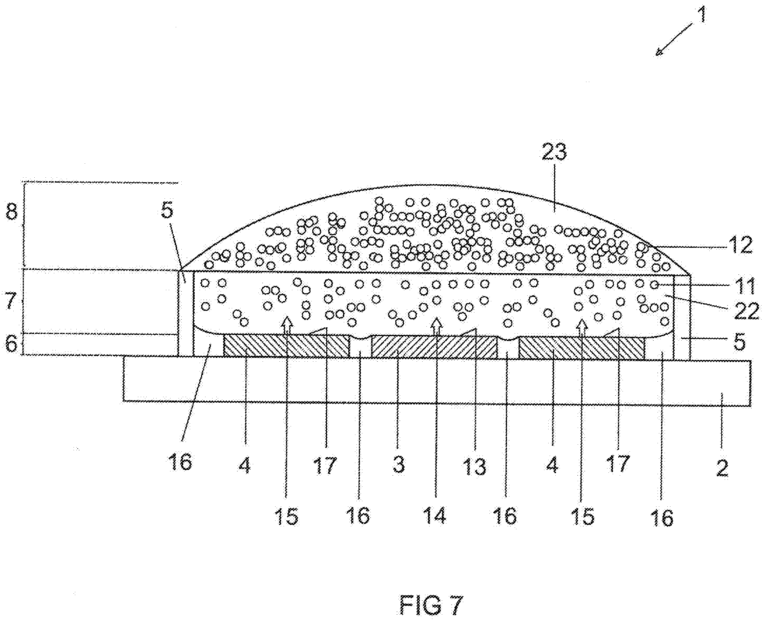

Figur 7 zeigt im Gegensatz zu Figur 6 eine Abwandlung, bei der zwischen der Streuschicht 8 in Linsenform und der Konversionsschicht 7 keine freie Lichtmischschicht 10 vorgesehen ist. Das Abstrahlprofil 21 entspricht dem aus Figur 6a. Die freie Lichtmischschicht 10 ist nicht zwingend notwendig. Allerdings müssen mehr Streupartikel 12 verwendet werden, um dieselbe Farbmischqualität wie in der Abwandlung von Figur 6 zu erreichen. Dies führt zu einer niedrigeren Effizienz. Darüber hinaus gilt die Beschreibung von Figur 6 auch für Figur 7.

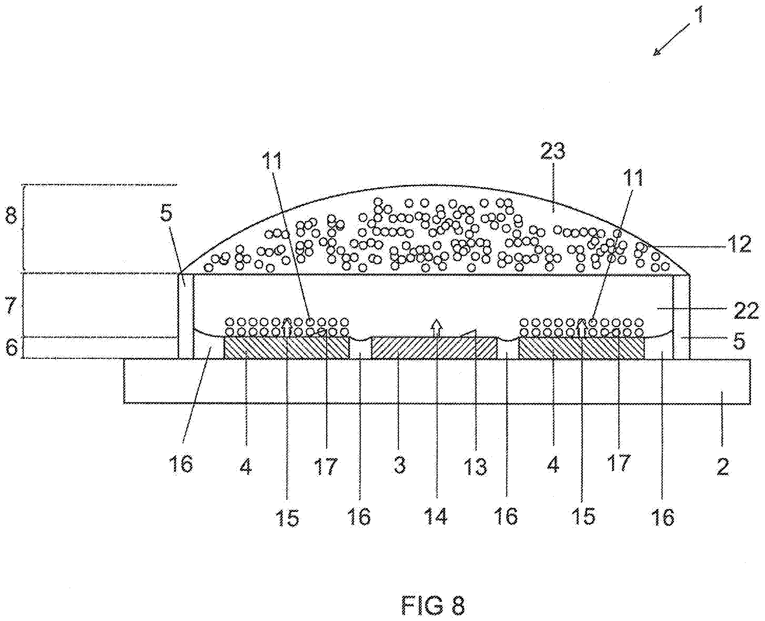

Figur 8 zeigt wie schon Figur 2 eine Abwandlung, bei der das phosphoreszente Material 11 inhomogen in der Konversionsschicht 7 verteilt ist. Das phosphoreszente Material 11 liegt in Form von Plättchen vor, die auf der Strahlungsaustrittsfläche 17 der InGaN-Halbleiterchips 4 angeordnet sind. Auf der Strahlungsaustrittsfläche 13 des InGaAlP-Halbleiterchip 3 ist kein phosphoreszentes Material 11 vorgesehen. Das von dem AlGaInP-Halbleiterchip 3 emittierte Licht wird in der Konversionsschicht 7 nicht absorbiert. Im Gegensatz zu Figur 2 weist die Streuschicht 8 die Form einer Linse auf. Die Streuschicht 8 schließt bündig mit den seitlichen Wänden 5 ab. In der Mitte zwischen den seitlichen Wänden weist die Streuschicht 8 ihre maximale Dicke auf. Mit anderen Worten ist mittig die maximale Anzahl an Streupartikel 12 vorgesehen.

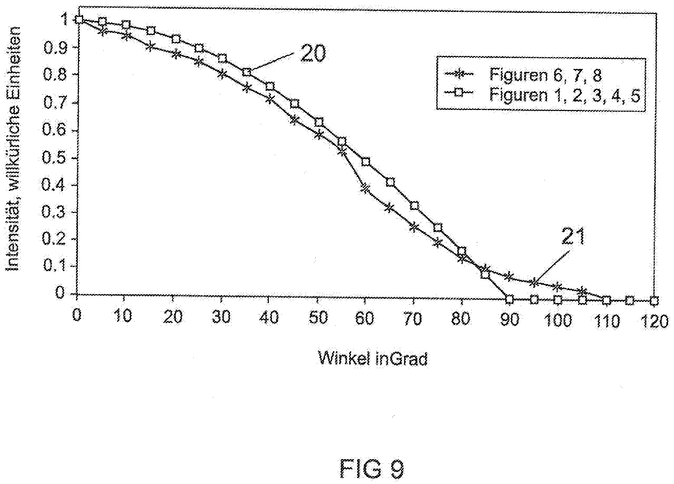

Figur 9 zeigt die simulierten Abstrahlprofile zu den optoelektronischen Bauelementen der Figuren 1, 2, 3, 4, 5, 6, 7 und 8. Die Abstrahlprofile zu den optoelektronischen Bauelementen der Figuren 1, 2, 3, 4 und 5 sind in der Simulation identisch. Es zeigt sich jeweils ein lambertsches Abstrahlprofil 20. Insbesondere fällt die Intensität bei 90 Grad auf Null ab. Die Abstrahlprofile zu den optoelektronischen Bauelementen der Figuren 6, 7 und 8 sind in der Simulation identisch. Es zeigt sich jeweils ein Abstrahlprofil 21, das bezüglich der Winkelverteilung breiter als ein Lambertsches Abstrahlprofil 20 ist. Insbesondere beträgt die Intensität bei 90 Grad in etwa 10 % der maximalen Intensität bei 0 Grad. Erst bei etwa 110 Grad fällt die Intensität auf 0 ab.

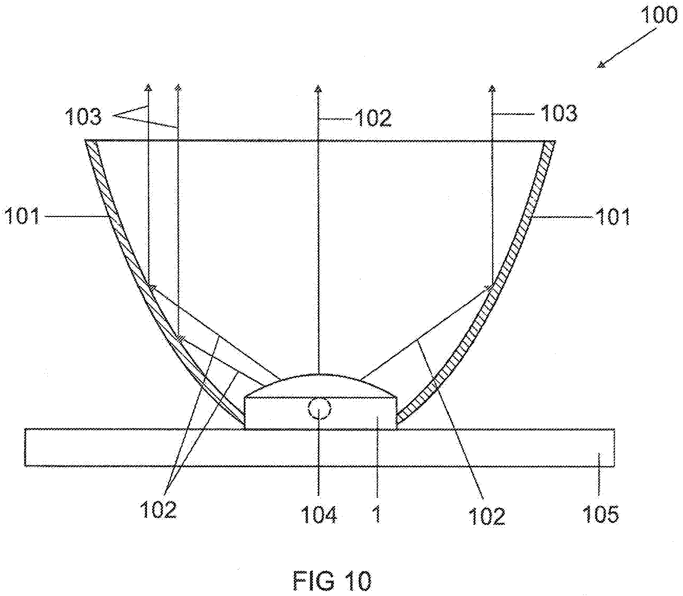

Figur 10 zeigt eine Leuchtvorrichtung 100 mit einem optoelektronischen Bauelement 1. Das optoelektronische Bauelement 1 ist an eine Sekundäroptik in Form eines Reflektors 101 gekoppelt. Das vom optoelektronischen Bauelement emittierte Mischlicht 102 wird vom Reflektor 101 in Vorwärtsrichtung reflektiert. Je größer der Winkel ist unter dem das optoelektronische Bauelement 1 Licht emittiert, umso höher ist die Intensität des vom Reflektor 101 in Vorwärtsrichtung reflektierten Mischlichtes 103. Der Reflektor 101 kann zumindest Bereichsweise die Form einer Parabel aufweisen. Das optoelektronische Bauelement 1 sitzt in der Ebene des Brennpunkts 104 der Parabel. Das Parabelminimum fehlt. Mit anderen Worten weist der Reflektor 101 nur die Seitenwände einer Parabel auf. Der Reflektor 101 schließt bündig mit dem optoelektronischen Bauelement 1 ab.

### Bezugszeichenliste

1 optoelektronisches Bauelement
2 Träger
3 erster Halbleiterchip
4 zweiter Halbleiterchip
5 seitliche Wände
6 Halbleiterchipebene
7 Konversionsschicht
8 Streuschicht
9 Lichtdurchmesser
10 freie Lichtmischschicht
11 phosphoreszentes Material, insbesondere Leuchtstoffpartikel
12 Streupartikel
13 erste Strahlungsaustrittsfläche
14 elektromagnetische Strahlung in einem ersten Spektralbereich
15 elektromagnetische Strahlung in einem zweiten Spektralbereich
16 seitlicher Verguss, mit Titandioxid gefülltes Silikon
17 zweite Strahlungsaustrittsfläche
18Lense on chip(=Tropfen klaren Vergussmaterials)
19a gemoldetes Glas
19b Silikonplättchen
20 schematisches Abstrahlprofil eines Lambertschen Strahlers
21 schematisches Abstrahlprofil für breitere als Lambertsche Strahler
22 Vergussmaterial, Konversionsschicht
23 Vergussmaterial, Streuschicht
100 Leuchtvorrichtung
101 Reflektor
102 Vom optoelektronischen Bauelement emittiertes Mischlicht
103 Vom Reflektor reflektiertes Mischlicht
104 Brennpunkt des zumindest Bereichsweise parabelförmigen Reflektors

## Patentansprüche

1. Optoelektronisches Bauelement (1) zur Mischung von elektromagnetischer Strahlung mit verschiedenen Wellenlängen im Fernfeld mit:
- einem Träger (2),
- mindestens einem auf dem Träger (2) angeordneten ersten Halbleiterchip (3) mit einer ersten Strahlungsaustrittsfläche (13) zur Emission von elektromagnetischer Strahlung in einem ersten Spektralbereich (14), wobei der erste Halbleiterchip (3) als AlGaInP-Halbleiterchip ausgebildet ist, der elektromagnetische Strahlung im roten und/oder gelben Spektralbereich emittiert,
- mindestens einem auf dem Träger (2) angeordneten zweiten Halbleiterchip (4) mit einer zweiten Strahlungsaustrittsfläche (17) zur Emission von elektromagnetischer Strahlung in einem zweiten Spektralbereich (15), wobei der zweite Halbleiterchip (4) als InGaN-Halbleiterchip ausgebildet ist, der elektromagnetische Strahlung im blauen Spektralbereich emittiert,
- wobei auf den vom Träger (2) abgewandten Strahlungsaustrittsflächen (13, 17) der Halbleiterchips (3,4) eine Streuschicht (8) vorgesehen ist, und
- wobei zwischen den vom Träger (2) abgewandten Strahlungsaustrittsflächen (13, 17) der Halbleiterchips (3, 4) und der Streuschicht (8) durchgehend eine Konversionsschicht (7) vorgesehen ist,
**dadurch gekennzeichnet, dass**
in der Konversionsschicht (7) nur auf der Strahlungsaustrittsfläche (13) des mindestens einen ersten Halbleiterchips (3) ein klares Vergussmaterial (22) in Form einer "Lense on chip" (18) angeordnet ist.

2. Optoelektronisches Bauelement gemäß Anspruch 1, wobei der erste (3) und der zweite Halbleiterchip (4) in einem einzigen Verguss, insbesondere in Form eines planaren Volumenvergusses, vergossen sind.

3. Optoelektronisches Bauelement gemäß einem der vorigen Ansprüche, wobei in der Konversionsschicht (7) als Konversionsmittel ein phosphoreszentes Material (11), insbesondere ein Yttrium-Gallium-Aluminium-Granat oder ein Lutetium Aluminium Granat, vorgesehen ist, das in einer Konzentration von 5 bis 25 Gewichtsprozent vorliegt.

4. Optoelektronisches Bauelement gemäß einem der vorigen Ansprüche, wobei in der Streuschicht (8) als Streumittel Streupartikel (12), insbesondere Aluminiumdioxid, Siliziumdioxid oder Titandioxid, in einer Konzentration von 0,05 bis 50 Gewichtsprozent, vorgesehen sind.

5. Optoelektronisches Bauelement gemäß einem der vorigen Ansprüche, wobei die Halbleiterchips (3, 4) bis zur Höhe ihrer aktiven Schichten in mit Titandioxid gefülltem Silikon mit einer Reflektivität von größer 95% eingegossen sind.

6. Optoelektronisches Bauelement gemäß einem der vorigen Ansprüche, wobei die Streuschicht (8) die Form einer Linse aufweist.

7. Optoelektronisches Bauelement gemäß einem der vorigen Ansprüche, wobei seitliche, reflektierende Wände (5) vorgesehen sind, die auf dem Träger (2) aufsetzen.

8. Leuchtvorrichtung (100) mit einem optoelektronischen Bauelement (1) gemäß einem der vorigen Ansprüche, wobei das optoelektronische Bauelement (1) an eine Sekundäroptik in Form eines Reflektors (101) gekoppelt ist.

9. Leuchtvorrichtung gemäß Anspruch 8, wobei der Reflektor (101) zumindest Bereichsweise die Form einer Parabel aufweist.

## Claims

1. An optoelectronic component (1) for mixing electromagnetic radiation having different wavelengths, in the far field, comprising:
- a carrier (2),
- at least one first semiconductor chip (3) arranged on the carrier (2) and having a first radiation exit surface (13) for emitting electromagnetic radiation in a first spectral range (14), wherein the first semiconductor chip (3) is embodied as an AlGaInP semiconductor chip that emits electromagnetic radiation in the red and/or yellow spectral range;
- at least one second semiconductor chip (4) arranged on the carrier (2) and having a second radiation exit surface (17) for emitting electromagnetic radiation in a second spectral range (15), wherein the second semiconductor chip (4) is embodied as an InGaN semiconductor chip that emits electromagnetic radiation in the blue spectral range,
- wherein a diffusing layer (8) is provided on the radiation exit surfaces (13, 17) of the semiconductor chips (3, 4) which face away from the carrier (2), and
- wherein a conversion layer (7) is provided continuously between the radiation exit surfaces (13, 17) of the semiconductor chips (3, 4) which face away from the carrier (2) and the diffusing layer (8),
**characterized in that**
a clear potting material (22)in the form of a "lens on chip" (18) is arranged in the conversion layer (7) on the radiation exit surface (13) of the first semiconductor chip (3) only.

2. The optoelectronic component according to claim 1, wherein the first (3) and the second semiconductor chip (4) are potted in a single potting, in particular in the form of a planar volume potting.

3. The optoelectronic component according to any of the preceding claims, wherein a phosphorescent material (11), in particular an yttrium gallium aluminum garnet or a lutetium aluminum garnet, which is present in a concentration of 5 to 25 percent by weight, is provided as conversion means in the conversion layer (7).

4. The optoelectronic component according to any of the preceding claims, wherein scattering particles (12), in particular aluminum dioxide, silicon dioxide or titanium dioxide, in a concentration of 0.05 to 50 percent by weight, are provided as diffusing means in the diffusing layer (8).

5. The optoelectronic component according to any of the preceding claims, wherein the semiconductor chips (3, 4) are cast up to the level of their active layers in silicone filled with titanium dioxide, having a reflectivity of greater than 95%.

6. The optoelectronic component according to any of the preceding claims,
wherein the diffusing layer (8) has the form of a lens.

7. The optoelectronic component according to any of the preceding claims, wherein lateral, reflective walls (5) are provided, which are seated on the carrier (2).

8. A lighting device (100) comprising an optoelectronic component (1) according to any of the preceding claims, wherein the optoelectronic component (1) is coupled to a secondary optical unit in the form of a reflector (101).

9. The lighting device according to claim 8, wherein the reflector (101) has the form of a parabola at least in regions.

## Revendications

1. Composant optoélectronique (1) destiné au mélange d'un rayonnement électromagnétique avec des longueurs d'onde différentes dans le champ distant avec :
- un support (2) ;
- au moins une première puce à semi-conducteurs (3), laquelle est disposée sur le support (2), avec une première surface de sortie de rayonnement (13) en vue de l'émission d'un rayonnement électromagnétique dans une première région du spectre (14) ; dans lequel la première puce à semi-conducteurs (3) se présente sous la forme d'une puce à semi-conducteurs de type AlGaInP, laquelle émet un rayonnement électromagnétique dans la région rouge et/ou dans la région jaune du spectre ;
- au moins une deuxième puce à semi-conducteurs (4), laquelle est disposée sur le support (2), avec une deuxième surface de sortie de rayonnement (17) en vue de l'émission d'un rayonnement électromagnétique dans une deuxième région du spectre (15) ; dans lequel la deuxième puce à semi-conducteurs (4) se présente sous la forme d'une puce à semi-conducteurs de type InGaN, laquelle émet un rayonnement électromagnétique dans la région bleue du spectre ;
- dans lequel une couche de diffusion (8) est prévue sur les surfaces de sortie de rayonnement (13, 17) des puces à semi-conducteurs (3,4) qui se trouvent à l'opposé du support (2) ; et
- dans lequel une couche de conversion (7) est prévue de manière continue entre les surfaces de sortie de rayonnement (13, 17) des puces à semi-conducteurs (3, 4) qui se trouvent à l'opposé du support (2) et la couche de diffusion (8) ;
**caractérisé en ce que**
une matière d'enrobage (22) de couleur claire, laquelle se présente sous la forme d'une lentille sur une puce (18) (« Lense on chip »), est disposée dans la couche de conversion (7), mais seulement sur la surface de sortie de rayonnement (13) de l'au moins une première puce à semi-conducteurs (3).

2. Composant optoélectronique selon la revendication 1, dans lequel la première puce à semi-conducteurs (3) et la deuxième puce à semi-conducteurs (4) sont coulées dans un seul enrobage, en particulier sous la forme d'une masse coulée de volume planaire.

3. Composant optoélectronique selon l'une des revendications précédentes, dans lequel une matière phosphorescente (11), en particulier un grenat d'yttrium, de gallium et d'aluminium ou un grenat de lutécium et d'aluminium, est prévue dans la couche de conversion (7) sous la forme d'un agent de conversion, laquelle matière phosphorescente existe dans une concentration comprise entre 5 et 25 % en poids.

4. Composant optoélectronique selon l'une des revendications précédentes, dans lequel des particules de diffusion (12), en particulier de l'oxyde d'aluminium, de l'oxyde de silicium ou de l'oxyde de titane, sont prévues dans la couche de diffusion (8) sous la forme de moyens de diffusion, lesquelles particules de diffusion existent dans une concentration comprise entre 0,05 et 50 % en poids.

5. Composant optoélectronique selon l'une des revendications précédentes, dans lequel les puces à semi-conducteurs (3, 4) sont moulées jusqu'à la hauteur de leurs couches actives dans du silicone rempli d'oxyde de titane, avec une réflectivité supérieure à 95 %.

6. Composant optoélectronique selon l'une des revendications précédentes, dans lequel la couche de diffusion (8) se présente sous la forme d'une lentille.

7. Composant optoélectronique selon l'une des revendications précédentes, dans lequel des parois (5) latérales réfléchissantes sont prévues, lesquelles sont mises en place sur le support (2).

8. Dispositif d'éclairage (100) avec un composant optoélectronique (1) selon l'une des revendications précédentes, dans lequel le composant optoélectronique (1) est couplé à une optique secondaire, laquelle se présente sous la forme d'un réflecteur (101).

9. Dispositif d'éclairage selon la revendication 8, dans lequel le réflecteur (101) se présente sous la forme d'une parabole, tout au moins par endroits.
